(19) Europäisches Patentamt
European Patent Office
Office européen des brevets

(11) **EP 2 483 732 B1**

(12) **EUROPÄISCHE PATENTSCHRIFT**

(45) Veröffentlichungstag und Bekanntmachung des Hinweises auf die Patenterteilung:
**21.06.2023** **Patentblatt 2023/25**

(21) Anmeldenummer: **10749799.2**

(22) Anmeldetag: **28.08.2010**

(51) Internationale Patentklassifikation (IPC):
**G02B 21/36** (2006.01)　　**G02B 27/56** (2006.01)
**G02B 27/58** (2006.01)　　**G01N 21/64** (2006.01)

(52) Gemeinsame Patentklassifikation (CPC):
**G01N 21/6458; G02B 21/367; G02B 27/56;
G02B 27/58;** H01L 27/146

(86) Internationale Anmeldenummer:
**PCT/EP2010/005295**

(87) Internationale Veröffentlichungsnummer:
**WO 2011/038817 (07.04.2011 Gazette 2011/14)**

(54) **VERFAHREN ZUR ERZEUGUNG EINES MIKROSKOPBILDES UND MIKROSKOP**

METHOD FOR GENERATING A MICROSCOPIC IMAGE AND MICROSCOPE

PROCÉDÉ DE PRODUCTION D'UNE IMAGE DE MICROSCOPIE, ET MICROSCOPE CORRESPONDANT

(84) Benannte Vertragsstaaten:
**AL AT BE BG CH CY CZ DE DK EE ES FI FR GB
GR HR HU IE IS IT LI LT LU LV MC MK MT NL NO
PL PT RO SE SI SK SM TR**

(30) Priorität: **30.09.2009　DE 102009043747**

(43) Veröffentlichungstag der Anmeldung:
**08.08.2012　Patentblatt 2012/32**

(73) Patentinhaber: **Carl Zeiss Microscopy GmbH
07745 Jena (DE)**

(72) Erfinder:
• **KLEPPE, Ingo
07749 Jena (DE)**
• **NOVIKAU, Yauheni
99510 Apolda (DE)**

(74) Vertreter: **Loritz, Rainer et al
Carl Zeiss AG
Konzernfunktion Recht und Patente
Patentabteilung Jena
Carl-Zeiss-Promenade 10
07745 Jena (DE)**

(56) Entgegenhaltungen:
EP-A1- 1 741 485　　　　WO-A2-2006/127692
DE-A1-102004 034 998　DE-A1-102008 009 216
US-A1- 2005 174 631　　US-A1- 2007 023 686
US-B1- 6 255 642

• **FIOLKA R ET AL: "Structured illumination in total internal reflection fluorescence microscopy using a spatial light modulator", OPTICS LETTERS, OPTICAL SOCIETY OF AMERICA, US, vol. 33, no. 14, 15 July 2008 (2008-07-15) , pages 1629-1631, XP001514976, ISSN: 0146-9592, DOI: 10.1364/OL.33.001629**

EP 2 483 732 B1

**Beschreibung**

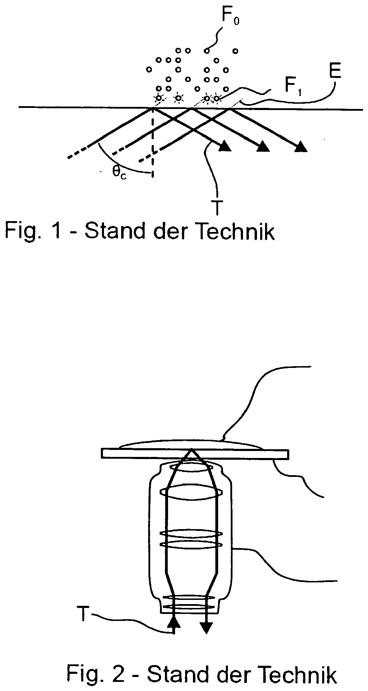

Die Mikroskopie unter Anwendung der sogenannten Totalreflexions-Fluoreszenz (engl. "total internal reflection fluorescence", TIRF) ist eine besondere Form der Fluoreszenzmikroskopie. Sie ist beispielsweise in WO 2006/127692 A2 (dort beispielsweise in Fig. 9 und 10C) oder in FIOLKA R ET AL: "Structured illumination in total internal reflection fluorescence microscopy using a spatial light modulator", OPTICS LETTERS, OPTICAL SOCIETY OF AMERICA, US, Bd. 33, Nr. 14, 15. Juli 2008 (2008-07-15), Seiten 1629-1631, offenbart. Fig. 1 erläutert die Zusammenhänge. Die Fluorophore $F_0$ der Probe P werden mittels eines evaneszenten Beleuchtungsfelds E ausschließlich in einer dünnen Schicht hinter der Grenzfläche zwischen Deckglas D und Probe zur Fluoreszenz $F_1$ angeregt. Das evaneszente Beleuchtungsfeld E in der Probe wird erzeugt, in dem die Anregungsstrahlung T innerhalb des Deckglases D unter einem Winkel $\theta_C$, der zur Totalreflexion führt, auf die Grenzfläche Deckglas-Probe geleitet wird. Indem nur die dünne Schicht zur Fluoreszenz angeregt wird, kann eine besonders hohe axiale Auflösung erzielt werden. Die optische axiale Auflösung eines TIRF-Mikroskops ergibt sich aus der Eindringtiefe d des evaneszenten Feldes in die Probe. In Abhängigkeit des Einfallswinkels $\theta$ ergibt sich die axiale Auflösung aus

$$d = \frac{\lambda}{4\pi\sqrt{n_1^2 \sin^2 \theta - n_2^2}},$$

wobei $\lambda$ die Anregungswellenlänge, $n_1$ die Brechzahl des Deckglases und $n_2$ die Brechzahl des Mediums der Probe ist.
Die Beleuchtung erfolgt typischerweise wie in Fig. 2 schematisch dargestellt durch das Mikroskopobjektiv O hindurch in dessen Randbereich so, dass das Beleuchtungslicht nach Verlassen des Objektivs O die optische Achse des Objektivs O unter einem Winkel kreuzt, der größer oder gleich dem Totalreflexionswinkel $\theta_C$ ist. Um die notwendigen großen Einfallswinkel für das Anregungslicht T zu ermöglichen, muss das Mikroskopobjektiv O eine hohe numerische Apertur aufweisen. Die entstehende Fluoreszenz wird durch dasselbe Objektiv O gesammelt und auf eine CCD-Kamera (nicht dargestellt) abgebildet.
Ebenfalls aus WO 2006/127692 A2 ist zur Erhöhung des mikroskopischen Auflösungsvermögens die Verwendung photoschaltbarer Fluoreszenzfarbstoffe bekannt (engl. "Photo-activated Localization Microscopy"; PALM, auch PAL-M). Durch Licht sehr geringer Intensität bei einer Aktivierungswellenlänge wird eine äußerst geringe Anzahl zufällig verteilter Fluorophore in einen anregbaren Zustand transformiert (aktiviert) und anschließend auf bekannte Weise durch Licht einer Anregungswellenlänge zur Fluoreszenz angeregt. Die übrigen, nichtaktivierten Fluorophore lassen sich durch die Anregungswellenlänge nicht zur Fluoreszenz anregen. Aufgrund der zufälligen Verteilung liegen die aktivierten und angeregten Fluorophore in der Regel räumlich soweit auseinander, dass die aus den Fluoreszenzereignissen entstehenden, beugungsbegrenzt verbreiterten Intensitätsverteilungen der Punktquellenabbilder einander nicht überlappen. Das gilt insbesondere auch für eine Projektion auf ein zweidimensionales Bild, in dem sich die Intensitätsverteilungen aufgrund der Beugungsverbreiterung zwangsläufig über mehrere Bildelemente (engl. "picture elements"; Pixel) erstrecken. In der PAL-Mikroskopie wird eine Vielzahl von Einzelbildern mit einer jeweils geringen Anzahl von in der Regel räumlich nichtüberlappenden Fluoreszenzereignissen aufgenommen. Die Aktivierung einer kleinen Gruppe von Fluorophoren wird dabei erst wiederholt, wenn die zuletzt aktivierten Fluorophore ausgebleicht sind. Die Ursprünge der einzelnen Fluoreszenzereignisse werden in den Einzelbildern anhand der beugungsverbreiterten Intensitätsverteilungen mittels einer Ausgleichsrechnung mit Subpixelauflösung lokalisiert und in ein hochauflösendes Ergebnisbild eingetragen.
Discloses a method to improve lateral resolution of optical imaging system by scanning the object with periodic pattern illumination.
Ein hochauflösendes Mikroskopieverfahren im Rahmen der Erfindung ist beispielsweise in US05867604 angesprochen, in der ein Objekt mit einer periodischen Struktur abgetastet wird.
In EP 1157297 B1 werden mittels strukturierter Beleuchtung nichtlineare Prozesse ausgenützt. Als Nichtlinearität dient die Sättigung der Fluoreszenz. Durch eine strukturierte Beleuchtung, welche mittels eines Beleuchtungsstrahlungsmodulators erzeugt wird, erfolgt eine Verschiebung des Objektraumspektrums relativ zur Übertragungsfunktion des optischen Systems. Konkret bedeutet die Verschiebung des Spektrums, dass Objektraumfrequenzen V0 bei einer Raumfrequenz V0 - Vm, wobei Vm die Frequenz der strukturierten Beleuchtung ist, übertragen werden. Bei gegebener, durch das System maximal übertragbarer Raumfrequenz ermöglicht dies den Transfer von um die Verschiebefrequenz Vm über der maximalen Frequenz der Übertragungsfunktion liegender Raumfrequenzen des Objektes. Dieser Ansatz erfordert einen Rekonstruktionsalgorithmus zur Bilderzeugung und die Verwertung mehrerer Aufnahmen für ein Bild. Die bezüglich der entsprechenden Beschreibung des auflösenden Mikroskopieverfahrens ebenfalls voll einbezogene EP 1157297 B1 verwendet also eine strukturierte Weitfeldbeleuchtung der Probe, wobei, beispielsweise durch ein Amplituden/Phasen-Gitter, eine streifenförmige Modulation aufgeprägt wird. Fluoreszenz in der Probe wird ebenfalls weitfelddetektiert. Die Modulation wird nun in mindestens drei verschiedene Drehlagen gebracht, z. B. 0°, 120° und 240°, und in jeder Drehlage wird die Modulation in mind. drei verschiedene Positionen verschoben. In jeder Verschiebung der Drehlagen (insgesamt also mind. 9 Bildpositionen) wird die Probe weitfelddetektiert. Weiter hat das Gitter Frequenzen möglichst nahe der Grenzfrequenz, zu deren Übertragung die verwendete-optische Anordnung in der Lage ist. Unter Verwendung einer Fourieranalyse erfolgt dann die erwähnte Spektrumverschiebung, wobei insbesondere die 0. und +/- 1. Beugungsordnung in den Bildern ausgewertet wird. Dieses Mikroskopieverfahren wird auch als SIM-Verfahren bezeichnet.

Eine Weiterbildung des SIM-Verfahrens kann mit einer linienförmigen Beleuchtung erreicht werden, die senkrecht zur Streifenrichtung der Modulation liegt. Man hat dann eine Linienbeleuchtung, wobei längs der Linie sich die Streifenstruktur wiederfindet. Die linienförmige Beleuchtung ist ihrerseits durch die Modulation strukturiert. Die linienförmige Beleuchtung erlaubt eine konfokale Schlitzdetektion und damit nochmals eine Auflösungssteigerung. Dieses Verfahren wird auch als SLIM abgekürzt.

Eine nochmalige Steigerung der Auflösung erhält man, wenn die Beleuchtungsstrahlungsmodulation an Beleuchtungsstrahlung ausgeführt wird, die derart intensiv ist, dass die Fluoreszenz der Probe in den hellen Bereich der strukturierten Beleuchtung eine Sättigung erreicht. Dann hat die Modulation auf der Probe bezüglich der Fluoreszenz keine Sinusverteilung mehr, sondern aufgrund der Sättigungseffekte noch höhere Harmonische jenseits der optischen Grenzfrequenz. Dieses Verfahren wird auch als saturated pattern excitation microscopy (SPEE) abgekürzt.

Die Erfindung beschreibt nachstehend ein Verfahren und eine Vorrichtung zur Erzielung einer mikroskopischen Auflösung unterhalb der Beugungsgrenze des Mikroskops gemäß den unabhängigen Ansprüchen. Bevorzugte Weiterbildungen sind Gegenstand der abhängigen Ansprüche

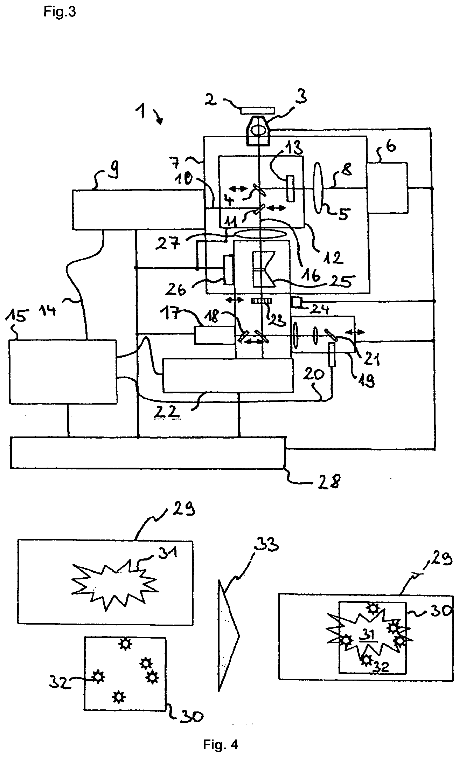

In Fig. 3 ist ein Mikroskop 1 dargestellt, das klassische Mikroskopieverfahren, d. h. Mikroskopieverfahren deren Auflösung beugungsbegrenzt ist, mit hochauflösenden Mikroskopieverfahren simultan ausführen kann, d. h. mit Mikroskopieverfahren deren Auflösung über die Beugungsgrenze hinaus gesteigert ist. Das Mikroskop 1 ist modular aufgebaut, und zur besseren Erläuterung der Erfindung wird es in einer umfangreichen Ausbaustufe beschrieben. Es ist aber auch eine reduzierte Bauweise mit weniger Modulen möglich. Auch ist der modulare Aufbau auch nicht zwingend; eine einteilige oder nicht-modulare Bauform ist ebenfalls möglich. Das Mikroskop 1 dieses Beispiels der Fig. 1 ist auf Basis eines herkömmlichen Laser-Scanning-Mikroskops aufgebaut und erfasst eine Probe 2.

Es weist ein Objektiv 3 auf, durch das die Strahlung für alle Mikroskopieverfahren läuft. Das Objektiv 3 bildet über einen Strahlteiler 4 die Probe zusammen mit einer Tubuslinse 5 auf einen CCD-Detektor 6 ab, der ein Beispiel für einen allgemein möglichen Flächendetektor ist. Insofern verfügt das Mikroskop 1 über ein herkömmliches Lichtmikroskopmodul 7, und der Strahlengang von der Probe 2 durch das Objektiv 3 und die Tubuslinse 5 zum CCD-Detektor 6 entspricht einem herkömmlichen Weitfeld-Detektionsstrahlengang 8. Der Strahlteiler 4 ist, wie durch den Doppelpfeil in Fig. 1 angedeutet, austauschbar, um zwischen Strahlteilern mit verschiedenen dichroitischen Eigenschaften bzw. achromatischen Strahlteilern gemäß US 2008/0088920 wechseln zu können.

In den Strahlengang zum Objektiv 3 ist weiter ein Laser-Scanning-Modul 9 angebunden, dessen LSM-Beleuchtungs- und Detektionsstrahlengang über einen Schaltspiegel 11, der ebenfalls Strahlteilerfunktionen hat, in den Strahlengang zum Objektiv 3 eingekoppelt ist. Der Strahlengang vom Schaltspiegel 11 zum Objektiv 3 durch den Strahlteiler 4 ist also ein Strahlengang, in dem Beleuchtungsstrahlengang und Detektionsstrahlengang vereint sind. Dies gilt sowohl hinsichtlich des Laser-Scanning-Moduls 9 also auch hinsichtlich des Weitfeld-Detektionsstrahlengangs 8, da, wie noch zu erläutern sein wird, am Schaltspiegel 11 auch Beleuchtungsstrahlung eingekoppelt wird, die zusammen mit dem Weitfeld-Detektionsstrahlengang 8, d. h. dem CCD-Detektor 6, Mikroskopieverfahren realisiert.

Der Schaltspiegel 11 und der Strahlteiler 4 sind zu einem Strahlteilermodul 12 zusammengefasst, wodurch die Möglichkeit besteht, den Schaltspiegel 11 und den Strahlteiler 4 anwendungsabhängig zu wechseln. Dies ist durch Doppelpfeile veranschaulicht. Weiter ist im Strahlteilermodul 12 ein Emissionsfilter 13 vorgesehen, das im Weitfeld-Detektionsstrahlengang 8 liegt und die spektralen Anteile, welche durch den Weitfeld-Detektionsstrahlengang 8 propagieren können, geeignet filtert. Natürlich ist auch das Emissionsfilter 13 im Strahlteilermodul 12 austauschbar.

Das Laser-Scanning-Modul 9 erhält für den Betrieb erforderliche Laserstrahlung über eine Lichtleitfaser 14 von einem Lasermodul 15.

In der in Fig. 1 dargestellten Bauweise wird am Strahlteilermodul 12, genauer am Schaltspiegel 14, ein Sammel-Beleuchtungsstrahlengang 16 eingekoppelt, durch den Beleuchtungsstrahlung für verschiedene Mikroskopieverfahren läuft. In diesen Sammel-Beleuchtungsstrahlengang 16 sind verschiedene Teil-Beleuchtungsstrahlengänge einzelner Beleuchtungsmodule eingekoppelt. Beispielsweise koppelt ein Weitfeldbeleuchtungsmodul 17 über einen Schaltspiegel 18 Weitfeldbeleuchtungsstrahlung in den Sammel-Beleuchtungsstrahlengang 16, so dass über eine Tubuslinse 27 und das Objektiv 3 die Probe 2 weitfeldbeleuchtet wird. Das Weitfeldbeleuchtungsmodul kann beispielsweise eine HBO-Lampe aufweisen. Als weiteres Beleuchtungsmodul ist ein TIRF-Beleuchtungsmodul 19 vorgesehen, das bei geeigneter Stellung des Schaltspiegels 18 eine TIRF-Beleuchtung realisiert. Das TIRF-Beleuchtungsmodul 19 erhält dazu Strahlung von Lasermodul 15 über eine Lichtleitfaser 20. Das TIRF-Beleuchtungsmodul 19 weist einen Spiegel 21 auf, der längsverschieblich ist. Durch die Längsverschiebung wird der Beleuchtungsstrahl, der vom TIRF-Beleuchtungsmodul 19 abgegeben wird, senkrecht zur Hauptausbreitungsrichtung des abgegebenen Beleuchtungsstrahls verschoben, wodurch im Ergebnis am Objektiv 3 die TIRF-Beleuchtung unter einem einstellbaren Winkel zur optischen Achse des Objektivs 3 einfällt. Auf diese Weise kann einfach der nötige Winkel der Totalreflexion am Deckglas sichergestellt werden. Natürlich sind auch andere Mittel geeignet, um diese Winkelverstellung zu bewirken. Auch kann das TIRF-Beleuchtungsmodul 19 als Weitfeldbeleuchtungsquelle arbeiten, indem der Spiegel 21 so eingestellt wird, dass der Beleuchtungsstrahl auf der optischen Achse einfällt.

Weiter ist an dem Sammel-Beleuchtungsstrahlengang der Beleuchtungsstrahlengang eines Manipulatormoduls 22 angekoppelt, das ebenfalls über eine nicht näher bezeichnete Lichtleitfaser Strahlung vom Lasermodul 15 erhält und eine punkt- oder linienförmige Strahlverteilung scannend über die Probe 2 führt. Das Manipulatormodul 22 entspricht also im Wesentlichen dem Beleuchtungsmodul eines Laserscanningmikroskops, und demzufolge kann das Manipulatormodul 22 auch mit dem Detektor des Laser-Scanning-Moduls 9 oder der Weitfeld-Detektion durch den CCD-Detektor 6 kombiniert betrieben werden.

Im Sammel-Beleuchtungsstrahlengang 16 ist weiter als Strahlungsmodulator ein Streifengitter 23 vorgesehen, das in einer Zwischenbildebene des Beleuchtungsstrahlenganges liegt und dessen Gitterkonstante unterhalb der Grenzfrequenz liegt, die mit dem Mikroskop 1 in die Probe 2 übertragen werden kann. Das Gitter 23 bewirkt eine streifenförmige Modulation der auf es einfallenden Beleuchtungsstrahlung. Das Gitter 23 ist quer zur optischen Achse des Sammel-Beleuchtungsstrahlengangs 16 verschieblich und kann auch aus dem Strahlengang herausgeschwenkt werden. Hierzu ist ein entsprechender Verschiebeantrieb 24 vorgesehen.

In Beleuchtungsrichtung dem Gitter nachgeordnet sitzt im Sammel-Beleuchtungsstrahlengang 16 weiter ein Bildfeldrotator 25, der von einem Rotatorantrieb 26 gedreht wird. Bei dem Bildfeldrotator kann es sich beispielsweise um ein Abbe-König-Prisma handeln.

Die Module und Antriebe sowie Detektoren des Mikroskops 1 sind alle über nicht näher bezeichnete Leitungen mit einer Steuereinrichtung 28 verbunden. Diese Verbindung kann beispielsweise über einen Daten- und Steuerbus erfolgen. Die Steuereinrichtung 28 steuert das Mikroskop 1 in verschiedene Betriebsmodi.

Das Steuergerät 28 ist ausgebildet, um am Mikroskop 1 klassische Mikroskopie, d. h. Weitfeldmikroskopie (WF), Laserscanningmikroskopie (LSM) und auch Fluoreszenzmikroskopie mit totaler interner Reflexion (TIRF) auszuführen und diese mit hochauflösenden Mikroskopieverfahren, wie in den eingangs erwähnten PAL-M, SIM, SLIM, SPEM, STED, RESOLFT, zu kombinieren und auch diese untereinander zu kombinieren. Das Mikroskop 1 der Fig. 1 weist im wesentlichen zwei zum Laserscannerbeleuchten geeignete Module auf, nämlich das Laserscanningmodul 9 sowie das Manipulatormodul 22. Natürlich sind auch andere Kombinationen möglich. Diese Module sind über Tubuslinsen mit dem Objektiv 3 auf die Probe 2 gekoppelt. Das Manipulatormodul 22 beinhaltet lediglich den Anregungsteil eines Laserscanningmoduls, also ohne Detektion. Dadurch kann die Probe punktförmig beleuchtet und der Beleuchtungsspot über die Probe 2 gerastert werden. Vorzugsweise befindet sich im Manipulatormodul 22 auch eine Umschalteinheit, z. B. eine Umschaltlinse oder Zylinderlinse, mit welcher eine Umschaltung zwischen einer punktförmigen und einer linienförmigen Beleuchtung erfolgt. Diese linienförmige Beleuchtung ist besonders dann vorteilhaft, wenn das Gitter 23, welches sich in einem Zwischenbild des Sammel-Beleuchtungsstrahlengangs 16 befindet, eingeschwenkt ist und senkrecht zur Linie der linienförmigen Beleuchtung liegt. Dann kann mittels des Manipulatormoduls 22 auf einfache Weise das SLIM-Mikroskopieverfahren realisiert werden.

Alternativ zum Gitter 23 kann auch ein variabel einstellbarer Streifenmodulator oder ein DMD zur Erzeugung einer strukturierten Beleuchtung in der Probe 2 eingesetzt werden. Dann ist natürlich der Verschiebeantrieb 24 sowie die Ein-/Ausschwenkbarkeit des Gitters 23 nicht mehr erforderlich.

Der Bildfeldrotator 25 erlaubt es, die strukturierte Beleuchtung, die durch das Gitter 23 (oder die dieses ersetzende Elemente) erzeugt werden, um die optische Achse des Sammel-Beleuchtungsstrahlenganges 16 zu drehen, so daß die strukturierte Beleuchtung in verschiedenen Winkeln in der Probe 2 liegt. Somit kann durch Betrieb des Manipulatormoduls 22 oder des Weitfeldbeleuchtungsmoduls 17, jeweils in Kombination mit geeigneter Verstellung des Gitters 23 durch das Steuergerät 28 SIM-, SLIM- oder SPEM-Mikroskopie mit dem Mikroskop 1 ausgeführt werden. Natürlich ist der Schaltspiegel 18 dann in die geeignete Stellung zu bringen.

Bei ausgeschwenktem Gitter 23 kann eine klassische Weitfeldbeleuchtung durch das Weitfeldbeleuchtungsmodul 17 bzw. eine klassische TIRF-Beleuchtung durch das TIRF-Beleuchtungsmodul 19 erfolgen.

Zur Umschaltung zwischen den einzelnen Betriebsarten werden die Schaltspiegel 18 und 11 sowie der Strahlteiler 4 geeignet eingestellt. Hierzu können in der Realisierung Klapp- oder Einschenkspiegel verwendet werden, so daß eine Umschaltung zwischen den Betriebsarten sequentiell erfolgen kann. Alternativ sind auch dichroitische Spiegel möglich, welche einen gleichzeitigen Betrieb der verschiedenen Module ermöglichen.

Der Strahlteiler 4 ist vorzugsweise als dichroitischer Strahlteiler ausgeführt, dessen Spektraleigenschaften so einstellbar sind, dass Spektralanteile von Fluoreszenzemission von Markierungsmolekülen, die mit Hilfe des CCD-Detektors 6 detektiert werden sollen, in den Weitfeld-Detektionsstrahlengang 8 gelangen und die übrigen Spektralkomponenten möglichst transmittiert werden. Zur Erhöhung der Flexibilität bezüglich der Verwendbarkeit von Markierungsmolekülen mit verschiedenen Emissionscharakteristiken sind im Strahlteilermodul 12 mehrere verschiedene Strahlteiler 4 und Emissionsfilter 13 austauschbar angeordnet, z. B. auf einem Filterrad.

Abb. 4 zeigt schematisch die Überlagerung verschiedener Mikroskopie-Bilder, die mit Hilfe des erfindungsgemäßen Kombinations-Mikroskops gewonnen werden. Das Mikroskopie-Bild 29 stammt dabei aus einem klassischen Mikroskopieverfahren, beispielsweise aus normaler Fluoreszenzmikroskopie unter Verwendung der Weitfeld-Beleuchtungsquelle 17 und der Weitfeld-Detektion. Das Mikroskopie-Bild 30 stammt hingegeben aus einem hochauflösenden Verfahren, beispielsweise einer SIM- oder PAL-Mikroskopie. Im Mikroskopie-Bild 29 finden sich Strukturen 31; Strukturen 32 sind im hochauflösenden Mikroskopie-Bild 30 vorhanden. Das Steuergerät 28 überlagert nun in einem durch einen Pfeil symbolisierten Überlagerungsvorgang 33 die jeweiligen Bilder zu einem Gesamtbild. Die Überlagerung kann zweidimensional, dreidimensional und für beide Varianten auch jeweils über die Zeit erfolgen. Fig. 2 zeigt exemplarisch eine zweidimensionale Darstellung. Fig. 2 ist weiter schematisch dafür, dass ein höher aufgelöstes Mikroskopie-Bild 30 mit einem niedriger aufgelösten Mikroskopie-Bild 29 kombiniert wird, d.h. dass die Kombination zweier unterschiedlich auflösender Mikroskopieverfahren zu einem Gesamtbild führen. Zu erkennen ist in Fig. 2, dass erst mit Hilfe des niedriger aufgelösten Mikroskopie-Bildes 29 ein Zusammenhang zwischen den hoch aufgelösten Details des höher aufgelösten Mikroskopie-Bildes 30 hergestellt werden kann.

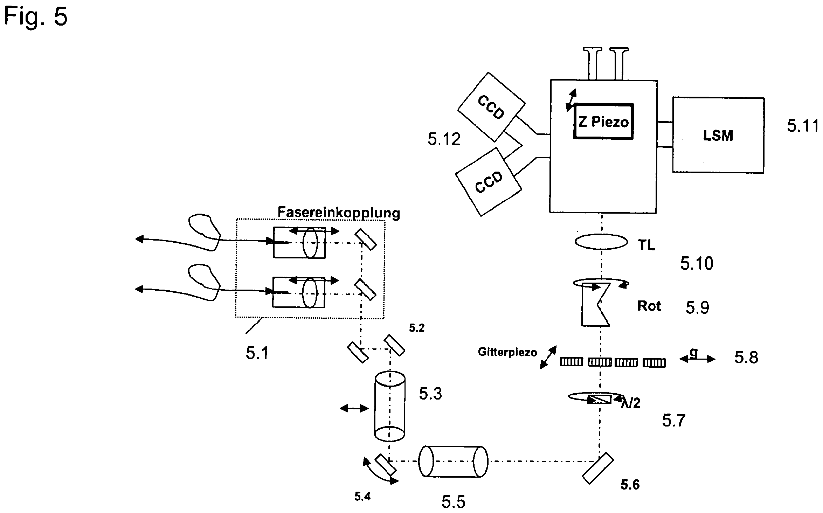

Abb.5 zeigt eine Ausführungsform einer für die Erfindung weiterhin optischen Anordnung.

Über eine Fasereinkopplung 5.1, die aus Lichtleitfasern, Kollimationslinsen und Umlenkspiegeln besteht wird.Beleuchtungslicht eingekoppelt.

Über Umlenkspiegel 5.2 gelangt es über ein vorzugsweise einstellbares Teleskop 5.3 zur Bildfeldreduktion im TIRF Mode auf einen kippbaren Spiegel 5.4, mittels dessen der TIRF Winkel verstellt werden kann.

Über eine weites Teleskop 5.5 und einen Umlenkspiegel 5.6 sowie eine drehbare lambda/ halbe Platte zur Drehung der Polarisation gelangt das kollimierte Licht in die Ebene eines Gitters 5.8 zur strukturierten Beleuchtung wie oben beschrieben , das vorzugsweise auswechselbar und mittels eines Piezoantriebs senkrecht zur optischen Achse fein verschiebbar ist und einem rotierfähigen Prisma zur Bilddrehung 5.9, eine Tubuslinse 5.10 in ein nur schematisch dargestelltes Mikroskop, das für die Z- Verstellung einen Piezoantrieb ausweist. An das Mikroskop ist in bekannter Weise ein LSM 5.11Strahlengang angekoppelt (siehe z.B. DE 19702753 A1). Zur Weitfelddetektion sind hier zwei parallele CCD Kameras 5.12 in der Detektion angeordnet.

Anhand Fig. 5 wird wiederum deutlich dass in einem Kombinationsgerät zur TIRF Beleuchtung und zur strukturierten (SIM) Beleuchtung abgespeicherte Bilder aus beiden Verfahren erzeugt werden können. Vorzugsweise wird zur TIRF Beleuchtung und anschließenden Detektion das Gitter ausgeschwenkt.

Mit einem oder mehreren Empfängern 5.1 wird bei eingeschwenktem Gitter ein hochauflösendes Weitfeldbild aus der Beleuchtung bei mehreren Gitterphasen und anschließender Berechnung ermittelt.

Bei Verwendung desselben Objektives sind die Bildfelder bei der SIM Aufnahme und der TIRF Aufnahme gleich so dass eine Verrechnung der Bilder ohne weiteres möglich ist. Bei Verwendung unterschiedlicher Objektive oder anderer Änderung der Aufnahmebedingungen könnten fachmännisch bekannte Naßnahmen zur Anpassung des Bildfeldes, beispielsweise mit einer Kalibrierung der verwendeten Objektive, und einer rechnerischen Korrektur der Bildfelder, erfolgen.

Die Datenaufnahme ist also eine zeitlich Abfolge von Bildern die zum einen alle nötigen Bilder für SIM enthält sowie ein TIRF Bild ohne Gitter im Strahlengang, also ohne Strukturierung. Die Reihenfolge der Aufnahme ist unerheblich und bietet nur je nach Hardware Geschwindigkeitsvorteile. Wenn beispielsweise das Verändern der Beleuchtung auf TIRF zeitaufwendig ist, macht es Sinn diese Bewegung nur einmal durchzuführen also das TIRF Bild am Anfang oder Ende der Bildserie aufzunehmen. Anders gesagt, das dünne TIRF Plättchen in der Nähe des Objektträgers kann durch die Berechnung "lateral" strukturiert werden.

Es kann auch eine durch Z- Verstellung stapelweise SIM Bilderzeugung erfolgen und beim unteren Bild des Stapels (der untersten Schicht des Objektes) wird zusätzlich eine TIRF Aufnahme erfolgen. Mit unterster Schicht ist hier die Schicht gemeint die in der Nähe des Deckglases liegt. Bei einem anderen als einem inversen Mikroskop könnte es sich auch um die "oberste" Schicht handeln. Überraschend entsteht also nach einer Verrechnung durch Multiplikation der Bilddaten für diese unterste Schicht ein bezüglich z, aber auch in Y/Y Richtung seitlich lateral gut aufgelöstes Bild.

Nach der Daten Aufnahme liegen also beispielsweise für SIM z.B. 15 Bilder vor (5 Phasen sind die 5 Phasen 0 Grad, 72 Grad, 144 Grad usw., 3 Bildrichtungen durch Verstellung von 5.9) und ein aufgenommenes TRIF Bild.

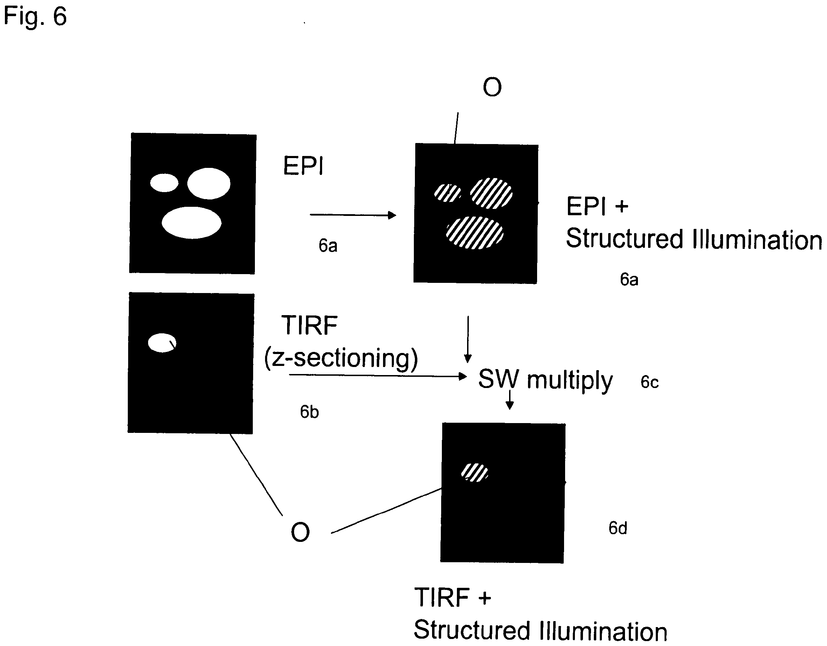

In Fig. 6 sind die gespeicherten Einzelbilder für TIRF 6ab und 6b für strukturierte (SIM) Beleuchtung dargestellt.

Diese werden nun in 6c) rechnerisch miteinander verknüpft (vorzugsweise multipliziert) wodurch ein Bild 6d) berechnet wird, das dem in der Nähe des Objektträgers aufgenommenen Bild zusätzlich eine laterale Strukturierung für ein Objekt O, das auf beiden Bildern vorhanden ist, verleiht.

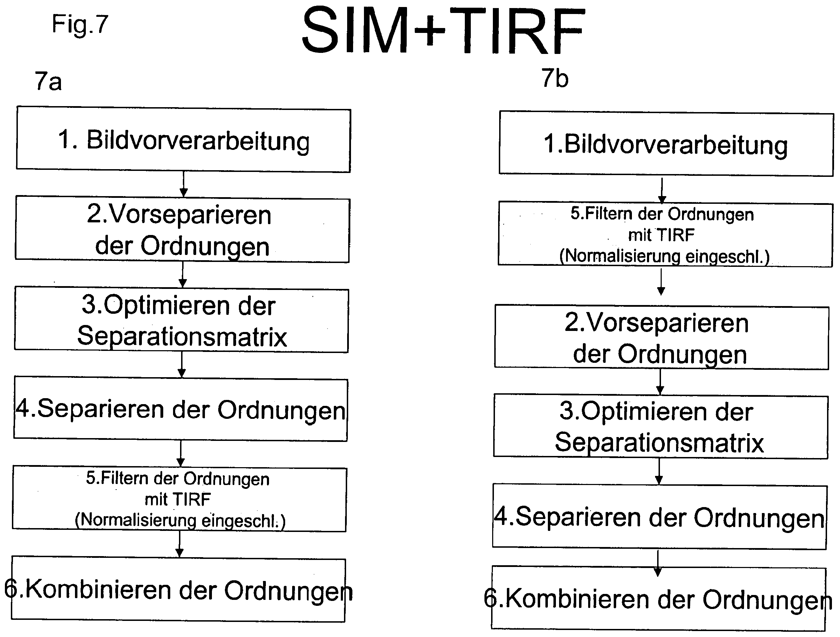

Die eigentliche Verknüpfung der Bilder besteht, wie in Fig.7 dargelegt, im Filterprozess der SIM Daten mit dem TIRF Bild, was durch einfache Multiplikation erfolgen kann. Das Bild zeigt zwei sinnvolle Abläufe der Verrechnung von SIM Daten und Stellen in an denen die Kombination mit dem TIRF Bild erfolgen kann.

Die Schritte 1-4, 6 sind alle Standard SIM Verrechnungen, Schritt 5 der hier neu eingeführte Schritt der TIRF Gewichtung,

Im Einzelnen ist der Ablauf wie folgt:

1. Die 15 Bilder werden wie für SIM üblich zunächst vorverarbeitet (z.B. Abzug von Hintergrund (evtl. durch die Aufnahme eines zusätzlichen Hintergrundbildes), Skalierung der jeweils 5 Phasen auf selbe mittlere Intensitäten, die Ränder der Bilder werden gedämpft um Artefakte der Fouriertransformation zu vermeiden).

2. Es schliesst sich der Schritt an an dem die Ordnungen zunächst pre-separiert werden um nach Optimierung der Separationsmatrix tatsächlich getrennt zu werden. Mit Ordnungen ist hier die durch die verschiedenen Beugungsordnungen des Gitters erzeugten Moiremuster gemeint, deren Linearkombination man in jedem einzelnen Bild beobachtet. Durch das Aufnehmen verschiedener Phasenbilder erhält man ein lineares Gleichungssystem, dessen Lösung die separierten Beiträge (Ordnungen) sind. Details der Herleitung finden sich auch in:

"Doubling the lateral resolution of wide field fluorescence microscopy" von Gustafson, Agard, Sedat, SPIE Vol.3919 (2000), 1605-7422

Um Relationen (Konzentrationen der Fluorophore) im Bild die nicht mit dem TIRF sectioning zu tun haben zu erhalten, sollte ausserdem nach der Multiplikation eine Normalisierung erfolgen die für den linearen Fall korrigiert, also die Quadratwurzel zieht, sodass laterale Intensitätsrelationen erhalten bleiben. Das heißt, Intensitätswerte die im TIRF und im SIM zu sehen sind erhalten nach der Gewichtung ihren ursprünglichen Wert zurück und sind nicht quadriert.

In Fig. 7a und 7b sind mögliche Abläufe dargestellt.

Es handelt sich um die Schritte (siehe auch die Beschreibung der Formeln und der Bezug zu diesen Schritten):

1. Bildvorverarbeitung (zum Beispiel Eliminieren des Hintergrundes, Glättungsfilter anwenden)
2. Vorseparieren der Ordnungen
3. Optimieren der Separationsmatrix
4. Separieren der Ordnungen
5. Filtern der Ordnungen mit TIRF, beispielsweise durch Multiplikation vorzugsweise mit anschließender Normalisierung (z.B. Quadratwurzel)
6. Kombinieren der Ordnungen ( gemeinsame Verrechnung und bildliche Darstellung)

In Fig. 7 a wird zunächst eine Aufnahme und Berechung der einzelnen Ordnungen eines mit strukturierter Beleuchtung aufgenommenen Bildes durchgeführt und dann mit dem TIRF Bild verrechnet und dann aus den Ordnungen ein Bild berechnet und abgespeichert (Schritt 5), in fig. 7b erfolgt erst eine TIRF Aufnahme und danach die Aufnahme des strukturierten Bildes und die Berechung der Ordnungen und Verrechnung mit dem TIRF Bild und anschließende Kombination der Ordnungen der Bilder.

Zu den mathematischen Grundlagen des SIM Verfahrens ist folgendes ergänzend auszuführen (siehe auch die angegebene Literatur):

**Beleuchtungsmuster im Fourier Raum:**

$$I(\mathbf{k}) = a_0 \delta(\mathbf{k}) + a_1 \left[ e^{-i\varphi} \delta(\mathbf{k} + \mathbf{k}_g) + e^{i\varphi} \delta(\mathbf{k} - \mathbf{k}_g) \right] + a_2 \left[ e^{-i2\varphi} \delta(\mathbf{k} + 2\mathbf{k}_g) + e^{i2\varphi} \delta(\mathbf{k} - 2\mathbf{k}_g) \right]$$

$$(1)$$

mit $a_0$, $a_1$ und $a_2$ als Amplituden der Stärke Beleuchtungsordnungen, $\mathbf{k}_g$ beschreibt den Gittervektor. Der Gittervektor $\mathbf{k}_g = (x_k, y_k)$ enthält Informationen über die Gitterfrequenz ("Pixel Größe"/$|\mathbf{k}_g|$) und Richtung (atan2($y_k$ / $x_k$)).

*Bildgebung:* $I(\mathbf{k})$ wird mit der Optischen Transferfunktion (OTF) multipliziert, $H_{ex}(\mathbf{k})$

$$I_{ex}(\mathbf{k}) = H_{ex}(\mathbf{k})I(\mathbf{k})$$

$$(2)$$

$I_{ex}(\mathbf{k})$ ist mit dem Objekt S(k) im Fourier Raum gefaltet

$$I_s(\mathbf{k}) = \int I_{ex}(\mathbf{k}')S(\mathbf{k}-\mathbf{k}')d\mathbf{k}' = \int H_{ex}(\mathbf{k}')I(\mathbf{k}')S(\mathbf{k}-\mathbf{k}')d\mathbf{k}' \tag{3}$$

$I_s(\mathbf{k})$ wird mit der Emissions OTF multipliziert, $H_{em}(\mathbf{k})$

$$I_{em}(\mathbf{k}) = H_{em}(\mathbf{k})I_s(\mathbf{k}) = H_{em}(\mathbf{k})\int H_{ex}(\mathbf{k}')I(\mathbf{k}')S(\mathbf{k}-\mathbf{k}')d\mathbf{k}' \tag{4}$$

Einsetzen von (1) in (4) führt zu

$$I_{em}(\mathbf{k}) = a_0\hat{D}_0(\mathbf{k}) + a_1\left[e^{-i\varphi}\hat{D}_{-1}(\mathbf{k}) + e^{i\varphi}\hat{D}_1(\mathbf{k})\right] + a_2\left[e^{-i2\varphi}\hat{D}_{-2}(\mathbf{k}) + e^{i2\varphi}\hat{D}_2(\mathbf{k})\right] \tag{5}$$

mit den Ordnungen:

$$\hat{D}_x(\mathbf{k}) = H_{em}(\mathbf{k})H_{ex}(x\mathbf{k}_g)S(\mathbf{k}-x\mathbf{k}_g), \tag{6}$$

Einsetzen der Ordnungsstärken $a_0$, $a_1$, und $a_2$ in $D_x(\mathbf{k})$ gibt

$$I_{em}(\mathbf{k}) = D_0(\mathbf{k}) + e^{-i\varphi}D_{-1}(\mathbf{k}) + e^{i\varphi}D_1(\mathbf{k}) + e^{-i2\varphi}D_{-2}(\mathbf{k}) + e^{i2\varphi}D_2(\mathbf{k}) \tag{7}$$

***Separieren der Ordnungen:*** Um fünf Ordnungen zu separieren, $D_0(\mathbf{k})$, $D_{-1}(\mathbf{k})$, $D_1(\mathbf{k})$, $D_{-2}(\mathbf{k})$ and $D_2(\mathbf{k})$, braucht man mindestens fünf Bilder ($N_p = 5$) aufgenommen mit verschiedenen Phasen, n = 1,..., $N_p$:

$$I_{em}^n(\mathbf{k}) = D_0(\mathbf{k}) + e^{-i\varphi_n}D_{-1}(\mathbf{k}) + e^{i\varphi_n}D_1(\mathbf{k}) + e^{-i2\varphi_n}D_{-2}(\mathbf{k}) + e^{i2\varphi_n}D_2(\mathbf{k}), \quad n = 1,...,N_p \tag{8}$$

Das Set (8) kann wie folgt in Matrix-Form geschrieben werden:

$$\mathbf{I} = \mathbf{A}\mathbf{D}'\tag{9}$$

mit

$$I = \left\{ I_{em}^n(\mathbf{k}) \right\}_{n=1,\ldots,N_p},$$
$$A = \left\{ 1, e^{-i\varphi_n}, e^{i\varphi_n}, e^{-i2\varphi_n}, e^{i2\varphi_n} \right\}_{n=1,\ldots,N_p},$$
$$D = \left\{ D_0(\mathbf{k}), D_{-1}(\mathbf{k}), D_1(\mathbf{k}), D_{-2}(\mathbf{k}), D_2(\mathbf{k}) \right\}$$

(10)

Bemerke, dass die Phasen so ausgewählt sein sollten, dass das lineare Gleichungssystem (8) aus linear unabhängigen Gleichungen besteht. Set (8) kann dann wie folgt nach $D_0(\mathbf{k})$, $D_{-1}(\mathbf{k})$, $D_1(\mathbf{k})$, $D_{-2}(\mathbf{k})$ und $D_2(\mathbf{k})$ gelöst werden.

*Optimieren der Separationsmatrix:* Separieren der Ordnungen gemäß der Gleichungen (8) setzt voraus, dass die Phasen $\square_n$ genau genug bekannt sind. Im *Optimieren der Separationsmatrix:* Separieren der Ordnungen gemäß der Gleichungen (8) setzt voraus, dass die Phasen $\square_n$ genau genug bekannt sind. Im Experiment jedoch können diese Werte manchmal substantiell von den Voreinstellungen abweichen, die Gitterfrequenz und Phase sollte also zusammen mit den Ordnungen aus den Daten bestimmt werden. Daher wird zunächst mit den Voreinstellungen für die Phasen vorsepariert **(Vorseparieren der Ordnungen gemäß Schritt 2 in Fig.7)** nach Gleichungssystem (8).

Anschliessend werden diese pre-separierten Ordnungen benutzt um die Separationsmatrix **A** zu optimieren **(Optimieren der Separationsmatrix, Schritt 3 in Fig. 7)** durch Minimierung der Krosskorrelationen zwischen den preseparierten Ordnungen. Mit dieser Matrix A werden dann abschliessend die Ordnungen-getrennt (Schritt 4 in Fig.7).

An dieser Stelle kann dann das Filtern der einzelnen Ordnungen mit dem TIRF Bild durch Multiplikation erfolgen **(Filtern der Ordnungen mit TIRF Schritt 5 in Fig. 7).** Normalisieren durch ziehen der Quadratwurzel erhält die relativen Intensitäten im Bild da Intensitäten die gleich hell im TIRF und Weitfeldbild zusehen sind, den identischen Helligkeitswert behalten, andere, die im TIRF weniger gut zu sehen sind jedoch dunkler dargestellt werden, so dass das gewünschte z-sectioning erfolgt.

Das Hochaufgelöste Bild wird dann genau wie bei Gustaffson et al. beschrieben durch Kombinieren der Ordnungen (verschieben im Frequenzraum und summieren der Ordnungen mit Gewichtung der OTF) zusammengesetzt, **(Kombinieren der Ordnungen, Schritt 6 in Fig. 7).**

## Patentansprüche

1. Verfahren zur Erzeugung eines Mikroskopbildes einer Probe (2), wobei

   a) die Probe (2) über ein Mikroskopobjektiv (3) über ein TIRF-Verfahren ohne Strukturierung beleuchtet und zur Bilderzeugung mindestens eines Probenbereichs Probenlicht detektiert wird und
   b) die Probe (2) mit einer streifenförmigen Modulation strukturiert beleuchtet wird und in unterschiedlichen Verschiebelagen der streifenförmigen Modulation Probenlicht jeweils zur Bilderzeugung mindestens eines Probenbereichs detektiert wird,

   wobei die nach a) und b) erzeugten Probenbilder (29) miteinander verrechnet, vorzugsweise multipliziert, werden und das Ergebnis zur Erzeugung eines neuen Probenbildes (30) abgespeichert wird.

2. Verfahren nach Anspruch 1, wobei:

   - ein erstes Mikroskopieverfahren durchgeführt wird, in dem die Probe (2) durch strukturierte Linien- oder Weitfeldbeleuchtung zur Lumineszenz angeregt wird, die Strukturierung vorzugsweise gedreht und für jede Drehstellung mehrmals verschoben wird, wobei mindestens drei Drehlagen und pro Drehlage mindestens drei Verschiebelagen realisiert werden, jeweils die lumineszierende Probe (2) mit einer vorbestimmten optischen Auflösung auf einen Flächendetektor abgebildet wird und aus den so erhaltenden Bildern (29) durch eine Fourieranalyse umfassende rechnerische Bearbeitung ein erstes Mikroskopie-Bild (30) mit über die vorbestimmte optische Auflösung hinaus gesteigerter Ortsauflösung erzeugt wird,
   und in einem zweiten Mikroskopieverfahren über ein TIRF-Beleuchtungsmodul die Probe (2) durch das Objektiv (3) so schräg beleuchtet wird, dass in der am Deckglas angeordneten Probe (2) Totalreflexion stattfindet, die ortsauflösend detektiert wird und ein zweites Mikroskopie-Bild erzeugt wird,
wobei erstes und zweites Mikroskopie-Bild miteinander bildpunktweise rechnerisch, vorzugsweise durch Multiplikation verknüpft werden.

3. Verfahren nach Anspruch 1 oder 2, wobei das Ergebnis der rechnerischen Verknüpfung bildlich dargestellt wird.

4. Verfahren nach Anspruch 1 oder 2,
**gekennzeichnet durch** die Verfahrensschritte:

- Separieren von Ordnungen durch Bildaufnahme bei mehreren unterschiedlichen Phasen der strukturierten Beleuchtung, wobei die Ordnungen Lösungen eines linearen Gleichungssystems sind, das aus den Bildern in den unterschiedlichen Phasen erhalten wird,
- Filtern der Ordnungen mit dem TIRF-Bild vorzugsweise durch Multiplikation
- Kombinieren der Ordnungen durch gemeinsame Verrechnung und bildliche Darstellung

5. Mikroskop (1) zur Durchführung des Verfahrens nach Anspruch 1, 2, 3 oder 4, wobei erste Beleuchtungsmittel (19) zur Erzeugung einer TIRF-Beleuchtung ohne Strukturierung und zweite Beleuchtungsmittel (17, 23) zur Erzeugung einer strukturierten Beleuchtung in unterschiedlichen Verschiebelagen der Struktur vorgesehen sind, Detektionsmittel (6) zur Detektion eines TIRF-Bildes und eines jeweiligen Bildes der strukturiert beleuchteten Probe (2) in unterschiedlichen Verschiebelagen der Struktur vorgesehen sind, Mittel zur Abspeicherung des TIRF-Bildes und der aus der strukturierten Beleuchtung in unterschiedlichen Verschiebelagen der Struktur berechneten Bilder der Probe (2) vorgesehen sind und Mittel (28) zur rechnerischen Verknüpfung der genannten Bilder, insbesondere durch Multiplikation, vorgesehen sind.

6. Mikroskop (1) nach Anspruch 5, ausgebildet zur Mikroskopie einer Probe (2) mit mindestens zwei sich in ihrer Auflösung unterscheidenden Mikroskopieverfahren, wobei das Mikroskop (1) aufweist:

- ein Objektiv (3), das für die Mikroskopieverfahren die Probe (2) erfasst,
- einen Detektionsstrahlengang und mindestens einen Beleuchtungsstrahlengang, die zumindest teilweise zusammenfallen und durch das Objektiv (3) laufen,
- ein an den Detektionsstrahlengang angebundenes Mikroskopmodul, das eine Tubuslinse (5) und einen Flächendetektor (6) aufweist und zusammen mit dem Objektiv (3) die Probe auf den Flächendetektor (6) abbildet,
- ein an den Beleuchtungsstrahlengang angebundenes Weitfeldbeleuchtungsmodul (17) zur Weitfeldbeleuchtung der Probe (2) durch das Objektiv (3), wobei das Weitfeldbeleuchtungsmodul (17) zur Abgabe von Beleuchtungsstrahlung bei mindestens zwei verschiedenen Wellenlängenbereichen ansteuerbar ist und
- ein im Beleuchtungsstrahlengang in Beleuchtungsrichtung dem Weitfeldbeleuchtungsmodul (17) nachgeordneter Beleuchtungsstrahlungsmodulator (23), der von einer Steuereinrichtung ansteuerbar im Beleuchtungsstrahlengang aktivier- und deaktivierbar ist und im aktivierten Zustand der Beleuchtungsstrahlung eine streifenförmige Modulation aufprägt, wobei der Beleuchtungsstrahlungsmodulator derart ansteuerbar ist, dass die streifenförmige Modulation senkrecht zu einer optischen Achse des Beleuchtungsstrahlenganges verschiebbar ist,
sowie ein ebenfalls von der Steuereinrichtung angesteuertes TIRF-Beleuchtungsmodul (19) aktivierbar an den Beleuchtungsstrahlengang angebunden ist, um die Probe (2) durch das Objektiv (3) so schräg zu beleuchten, dass in einem auf der Probe angeordneten Deckglas Totalreflexion stattfindet und das in einem evaneszenten Feld angeregte Probenlicht auf einen Detektor (6) gelangt dessen Detektionssignale abgespeichert werden wobei eine Detektion eines in einem evaneszenten Feld angeregten Probenvolumens erfolgt,
Detektionsmittel (6) zur Detektion eines TIRF-Bildes ohne Strukturierung und eines Bildes der strukturiert beleuchteten Probe (2) vorgesehen sind, Mittel zur Abspeicherung des TIRF-Bildes und der aus der strukturierten Beleuchtung in unterschiedlichen Verschiebelagen der Struktur erzeugten Bilder (29) der Probe (2) vorgesehen sind und Mittel zur rechnerischen Verknüpfung der genannten Bilder, insbesondere durch Multiplikation, vorgesehen sind.

7. Mikroskop (1) nach einem der Ansprüche 5-6, wobei Mittel zur bildlichen Darstellung des durch Verrechnung entstandenen Bildes vorgesehen sind.

**Claims**

1. Method for generating a microscope image of a sample (2), wherein

   a) the sample (2) is illuminated via a microscope objective (3) by way of a TIRF method without structuring and sample light is detected for the purpose of generating an image of at least one sample region, and
   b) the sample (2) is illuminated in a structured fashion with a strip-shaped modulation and, in different displacement positions of the strip-shaped modulation, sample light is detected in each case for the purpose of generating an image of at least one sample region, wherein the sample images (29) generated according to a) and b) are computed with one another, preferably multiplied together, and the result is stored for the purpose of generating a new sample image (30).

2. Method according to Claim 1, wherein:

   - a first microscopy method is carried out, in which the sample (2) is excited to luminescence by structured line or wide field illumination, the structuring is preferably rotated and displaced a number of times for each rotational position, wherein at least three rotational positions and at least three displacement positions per rotational position are realized, the luminescent sample (2) is in each case imaged with a predetermined optical resolution onto an area detector and, from the images (29) thus obtained, a first microscopy image (30) with a spatial resolution that is increased beyond the predetermined optical resolution is generated by computational processing comprising a Fourier analysis,
   and in a second microscopy method, by way of a TIRF illumination module, the sample (2) is illuminated through the objective (3) obliquely in a manner such that total internal reflection takes place in the sample (2) arranged on the coverslip, and this total internal reflection is detected in a spatially resolving manner, and a second microscopy image is generated,
   wherein the first and second microscopy images are linked together pixel by pixel computationally, preferably by multiplication.

3. Method according to Claim 1 or 2, wherein the result of the computational linking is represented in image form.

4. Method according to Claim 1 or 2,
   **characterized by** the following method steps:

   - separating orders by image recording in the case of a plurality of different phases of the structured illumination, wherein the orders are solutions of a linear equation system obtained from the images in the different phases,
   - filtering the orders with the TIRF image preferably by multiplication,
   - combining the orders by joint computation and representation in image form.

5. Microscope (1) for carrying out the method according to Claim 1, 2, 3 or 4,
   wherein provision is made of first illumination means (19) for generating a TIRF illumination without structuring and second illumination means (17, 23) for generating a structured illumination in different displacement positions of the structure, provision is made of detection means (6) for detecting a TIRF image and a respective image of the sample (2) illuminated in a structured fashion in different displacement positions of the structure, provision is made of means for storing the TIRF image and the images of the sample (2) that are calculated from the structured illumination in different displacement positions of the structure, and provision is made of means (28) for computationally linking the stated images, in particular by multiplication.

6. Microscope (1) according to Claim 5, designed for the microscopy of a sample (2) with at least two microscopy methods that differ in their resolution, wherein the microscope (1) comprises:

   - an objective (3), which captures the sample (2) for the microscopy methods,
   - a detection beam path and at least one illumination beam path, which at least partly coincide and pass through the objective (3),
   - a microscope module, which is connected to the detection beam path and has a tube lens (5) and an area detector (6) and, together with the objective (3), images the sample onto the area detector (6),
   - a wide field illumination module (17) connected to the illumination beam path and intended for the wide field illumination of the sample (2) through the objective (3), wherein the wide field illumination module (17) is controllable for emitting illumination radiation in at least two different wavelength ranges, and

- an illumination radiation modulator (23), which is disposed in the illumination beam path downstream of the wide field illumination module (17) in the illumination direction and is controllably activatable and deactivatable by a control device in the illumination beam path and imposes a strip-shaped modulation on the illumination radiation in the activated state, wherein the illumination radiation modulator is controllable in such a way that the strip-shaped modulation is displaceable perpendicularly to an optical axis of the illumination beam path, and a TIRF illumination module (19), which is likewise controlled by the control device, is connected to the illumination beam path in an activatable manner in order to illuminate the sample (2) through the objective (3) obliquely in such a manner that total internal reflection takes place in a coverslip arranged on the sample and the sample light excited in an evanescent field passes to a detector (6), the detection signals of which are stored, wherein a sample volume excited in an evanescent field is detected, provision is made of detection means (6) for detecting a TIRF image without structuring and an image of the sample (2) illuminated in a structured fashion, provision is made of means for storing the TIRF image and the images (29) of the sample (2) that are generated from the structured illumination in different displacement positions of the structure, and provision is made of means for computationally linking the stated images, in particular by multiplication.

7. Microscope (1) according to either of Claims 5-6, wherein provision is made of means for representing in image form the image produced as a result of computation.

**Revendications**

1. Procédé permettant de former une image de microscopie d'un échantillon (2), dans lequel

   a) l'échantillon (2) est éclairé sans structuration par un objectif de microscope (3) à l'aide d'un procédé TIRF, et une lumière d'échantillon est détectée pour former une image d'au moins une zone d'échantillon, et
   b) l'échantillon (2) est éclairé de manière structurée avec une modulation en forme de frange, et dans différentes positions de décalage de la modulation en forme de frange, la lumière d'échantillon est détectée respectivement pour former une image d'au moins une zone d'échantillon, dans lequel les images d'échantillon (29) formées selon a) et b) sont calculées entre elles, de préférence multipliées, et le résultat est mémorisé pour former une nouvelle image d'échantillon (30).

2. Procédé selon la revendication 1, dans lequel :

   - un premier procédé de microscopie est effectué dans lequel l'échantillon (2) est excité à la luminescence par un éclairage structuré linéaire ou en champ large, une rotation est de préférence appliquée à la structuration ainsi que des décalages multiples de celle-ci pour chaque position de rotation, dans lequel au moins trois positions de rotation et pour chaque position de rotation au moins trois positions de décalage sont réalisées, l'échantillon luminescent (2) est respectivement représenté sur un détecteur à jonction à une résolution optique prédéterminée, et à partir des images (29) ainsi obtenues, par un traitement mathématique comprenant une analyse de Fourier, une première image de microscopie (30) avec une résolution locale augmentée au-delà de la résolution optique prédéterminée est formée, et
   dans un deuxième procédé de microscopie, l'échantillon (2) est éclairé par un module d'éclairage TIRF en biais à travers l'objectif (3) de sorte que dans l'échantillon (2) disposé sur la lamelle couvre-objet, une réflexion totale a lieu qui est détectée avec une résolution locale, et une deuxième image de microscopie est formée,
   dans lequel la première et la deuxième image de microscopie sont combinées mathématiquement l'une avec l'autre pixel par pixel, de préférence par multiplication.

3. Procédé selon la revendication 1 ou 2, dans lequel le résultat de la combinaison mathématique est représenté graphiquement.

4. Procédé selon la revendication 1 ou 2, **caractérisé par** les étapes de procédé consistant à :

   - différencier des ordres par prise de vue à plusieurs phases différentes de l'éclairage structuré, les ordres étant des solutions d'un système d'équations linéaires qui est obtenu à partir des images dans les différentes phases,
   - filtrer les ordres à l'aide de l'image TIRF, de préférence par multiplication,
   - combiner les ordres par un calcul commun et une représentation graphique.

**5.** Microscope (1) permettant d'effectuer le procédé selon la revendication 1, 2, 3 ou 4, dans lequel des premiers moyens d'éclairage (19) sont prévus pour produire un éclairage TIRF sans structuration et des deuxièmes moyens d'éclairage (17, 23) sont prévus pour produire un éclairage structuré dans différentes positions de décalage de la structure, des moyens de détection (6) sont prévus pour détecter une image TIRF et une image respective de l'échantillon (2) éclairé de manière structurée dans différentes positions de décalage de la structure, des moyens sont prévus pour mémoriser l'image TIRF et les images de l'échantillon (2) calculées à partir de l'éclairage structuré dans différentes positions de décalage de la structure, et des moyens (28) sont prévus pour la combinaison mathématique desdites images, en particulier par multiplication.

**6.** Microscope (1) selon la revendication 5, réalisé pour la microscopie d'un échantillon (2) par au moins deux procédés de microscopie qui se distinguent par leur résolution, le microscope (1) présentant :

- un objectif (3) qui détecte l'échantillon (2) pour le procédé de microscopie,
- une trajectoire de faisceau de détection et au moins une trajectoire de faisceau d'éclairage qui coïncident au moins partiellement et passent à travers l'objectif (3),
- un module de microscope associé à la trajectoire de faisceau de détection et qui présente une lentille tubulaire (5) et un détecteur à jonction (6) et représente avec l'objectif (3) l'échantillon sur le détecteur à jonction (6),
- un module d'éclairage en champ large (17) associé à la trajectoire de faisceau d'éclairage pour l'éclairage en champ large de l'échantillon (2) à travers l'objectif (3), dans lequel le module d'éclairage en champ large (17) peut être piloté pour délivrer un rayonnement d'éclairage à au moins deux plages de longueurs d'onde différentes, et
- un modulateur de rayonnement d'éclairage (23) placé en aval du module d'éclairage en champ large sur la trajectoire de faisceau d'éclairage dans la direction d'éclairage et qui peut être piloté par un dispositif de commande pour être activé et désactivé dans la trajectoire de faisceau d'éclairage, et imprime à l'état activé une modulation en forme de franges au rayonnement d'éclairage, dans lequel le modulateur de rayonnement d'éclairage peut être piloté de telle sorte que la modulation en forme de franges peut être décalée perpendiculairement à un axe optique de la trajectoire de faisceau d'éclairage, ainsi qu'un module d'éclairage TIRF (19) également piloté par le dispositif de commande et associé à la trajectoire d'éclairage de manière à pouvoir être activé afin d'éclairer l'échantillon (2) en biais à travers l'objectif (3) de façon que dans une lamelle couvre-objet disposée sur l'échantillon, une réflexion totale a lieu, et la lumière d'échantillon excitée dans un champ évanescent atteint un détecteur (6) dont les signaux de détection sont mémorisés, dans lequel une détection d'un volume d'échantillon excité dans un champ évanescent a lieu, des moyens de détection (6) sont prévus pour détecter une image TIRF sans structuration et une image de l'échantillon éclairé (2) de manière structurée, des moyens sont prévus pour mémoriser l'image TIRF et les images (29) formées à partir de l'éclairage structurée dans différentes positions de décalage de la structure de l'échantillon (2), et des moyens sont prévus pour la combinaison mathématique desdites images, en particulier par multiplication.

**7.** Microscope (1) selon l'une quelconque des revendications 5 à 6, dans lequel des moyens sont prévus pour la représentation graphique de l'image créée par le calcul.

Fig. 1 - Stand der Technik

Fig. 2 - Stand der Technik

Fig.3

Fig. 4

Fig. 5

EP 2 483 732 B1

Fig. 6

# SIM+TIRF

Fig.7

7a

| 1. Bildvorverarbeitung |
|---|

↓

| 2.Vorseparieren der Ordnungen |
|---|

↓

| 3.Optimieren der Separationsmatrix |
|---|

↓

| 4.Separieren der Ordnungen |
|---|

↓

| 5.Filtern der Ordnungen mit TIRF (Normalisierung eingeschl.) |
|---|

↓

| 6.Kombinieren der Ordnungen |
|---|

7b

| 1.Bildvorverarbeitung |
|---|

↓

| 5.Filtern der Ordnungen mit TIRF (Normalisierung eingeschl.) |
|---|

↓

| 2.Vorseparieren der Ordnungen |
|---|

↓

| 3.Optimieren der Separationsmatrix |
|---|

↓

| 4.Separieren der Ordnungen |
|---|

↓

| 6.Kombinieren der Ordnungen |
|---|

EP 2 483 732 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2006127692 A2
- US 05867604 A
- EP 1157297 B1
- US 20080088920 A
- DE 19702753 A1

**In der Beschreibung aufgeführte Nicht-Patentliteratur**

- Structured illumination in total internal reflection fluorescence microscopy using a spatial light modulator. **FIOLKA R et al.** OPTICS LETTERS. OPTICAL SOCIETY OF AMERICA, 15. Juli 2008, vol. 33, 1629-1631
- **GUSTAFSON ; AGARD ; SEDAT.** Doubling the lateral resolution of wide field fluorescence microscopy. *SPIE,* 2000, vol. 3919, 1605-7422